# EUROPEAN PATENT SPECIFICATION

(11) **EP 1 393 019 B1**
(45) Date of publication and mention of the grant of the patent: **13.08.2008**
(21) Application number: 02735589.0
(22) Date of filing: 29.05.2002
(51) Int. Cl.: G01D 4/00, G01D 5/34, G01D 5/36, G01F 15/06, G01F 15/075, G01D 3/028, G01R 11/18

(54) **OPTICAL SENSOR FOR UTILITY METERS**
OPTISCHER SENSOR FÜR VERBRAUCHSZÄHLER
CAPTEURS OPTIQUES POUR COMPTEURS A USAGE GENERAL

(30) Priority: 05.06.2001 GB 0113642; 29.10.2001 GB 0125897
(43) Date of publication of application: 03.03.2004
(73) Proprietor: NGRID Intellectual Property Limited, London WC2N 5EH (GB)
(72) Inventor: ULLATHORNE, David Paul, Nottingham NG5 2NG (GB); SHAN, Qing, Leicestershire LE11 3PF (GB); TAILOR, Chandra, Leicestershire LE11 3LF (GB)
(74) Representative: Kunz, Herbert
(86) International application number: PCT/GB2002/002501
(87) International publication number: WO 2002/099360

(56) References cited:
- GB-A- 2 101 296
- GB-A- 2 192 708

## Description

The present invention relates to a method and apparatus for providing an electrical output from a meter, particularly a meter having a movable member, such as a rotary indicator arm, which is arranged to move in dependence upon an amount of a commodity measured by the meter.

GB-A-2 262 602 discloses an output device for a commodity meter of the kind having a rotary indicator member which rotates in dependence upon the amount of the commodity metered by the meter. The output device comprises a housing adapted to be secured to the meter and containing a light emitting device, a pair of photo-detectors and means for producing an output signal. The light emitting device is arranged to direct a light beam towards the rotary indicator member for modulation by the indicator member as it rotates and for reflection of the light beam back to the pair of photo-detectors which are matched in performance. In order to cancel the influence of ambient light, the pair of photo-detectors is positioned such that when the indicator member is modulating the portion of the beam incident on the first photodetector, it is not modulating the portion of the beam incident on the second photodetector to the same extent. The means for producing an output signal produces a signal representative of the difference between the respective outputs of the pair of matched photo detectors.

GB2192708 discloses an electro-optical sensor arrangement which records the number of revolutions of a meter index pointer includes a phototransducer comprising a L.E.D. and a photo-transistor which normally receives light pulses reflected from a meter dial to provide a pulsed input signal to a signal processing circuit The processing circuit comprises a Schmitt trigger, which receives clock pulses five times per second from a timer, and a flip-flop, the output of which is normally high and is feedback connected via a diode and a resistor to the data input of the Schmitt trigger. The flip-flop output goes high only when the pointer interrupts the path of an IR beam, whereby a pulse is fed to a logger via a monostable and a switch. The flip-flop does not reset until substantially the whole pointer passes Out of the beam path.

GB2101296 discloses a system in which the movements of a pointer of a meter past a specific point around a scale of the meter are monitored by means of a pulsed beam of incident light from an LED source and sensed, after reflection from the scale, by a phototransistor. As the pointer moves through the light beam, the average amplitude of pulses received by the transducer falls then rises and a trigger pulse is initiated by a level detector when the average amplitude reaches a first threshold during the fall. The nigger pulse is terminated when the average amplitude reaches a second threshold during the subsequent rise.

It is an object of the present invention to provide a reliable method and apparatus for providing an electrical output from a meter which does not require a pair of matched photo detectors, eliminating the need for them to be matched in performance, keeping the number of required components low thus reducing costs and reducing any influences from ambient light which can make the detection of the light beam difficult.

According to a first aspect of the present invention there is provided a method for providing an electrical output from a meter having a movable member arranged to move through a regular path in dependence upon an amount of a commodity measured by the meter, the method comprising providing a light source to direct a light beam towards a portion of the regular path followed by the movable member and a photodetector to receive a reflected beam from the portion of the regular path at which the light source is directed or from a portion of the movable member when it is at that portion of its regular path, the movable member having a different reflectivity from the portion of the regular path at which the light source is directed; sampling an electrical output from the photodetector whilst the light source is emitting light; characterised by further including sampling an electrical output from the photodetector whilst the light source is not emitting light; producing an electrical output signal representative of the difference between the two sampled electrical outputs and repeating the two samplings and production of an electrical output signal at appropriate intervals.

During the periods between the two samplings and the production of an electrical output signal, the components used to perform the method may be in a so-called 'sleep' mode to conserve energy.

The output signal representative of the difference between the two sampled electrical outputs is indicative of the signal from the light source reflected from the path of the movable member with any influence from ambient light removed. The output signal is produced using a single photodetector reducing the number of parts required and so reducing complexity. cost and power consumption. Furthermore, since a single photodetector is used any effects due to temperature changes or ageing are compensated for by determining the difference between two readings from the photodetector.

The output signal will be different depending upon whether or not the movable member, which may for example be a rotary indicator arm, is occupying the portion of the path at which the light source is directed. By repeating the sampling at appropriate intervals it can be determined when the movable member or rotary indicator arm passes the portion of its regular path which is being monitored. This can be represented by a suitable electrical signal such as a pulse. By determining how many times the movable member or rotary arm has passed the monitoring point the amount of commodity metered can be determined and may be conveniently indicated by an electrical signal. The electrical signal indicative of the number of cycles of the movable member, such as the number of rotations of a rotary indicator arm, is indicative of the amount of commodity measured by the meter and is conveniently available as an electrical signal which can be used for many applications such as automatic or remote meter reading using a radio transceiver for example or automatic energy monitoring and control.

The method may be carried out on an existing meter having for example a rotary pointer or indicator arm which makes one rotation for the measurement of a particular amount of commodity measured by the meter. The rotary pointer is often red and is relatively less reflective than the background to the pointer which is often white, forming the portion of the regular path of the pointer to which the light beam is directed. Alternatively the method could be applied to a mechanical meter which does not have a rotary pointer by performing the method on a portion of the inner mechanical moving shafts or levers inside a meter such as a conventional positive displacement domestic gas meter of the kind available in the United Kingdom under the designation U6. A portion of one of the inner mechanical moving shafts or levers may be provided with a suitable indicator able to reflect an electromagnetic beam more or less well than when the indicator is not in the path of the beam.

The light beam could be light from a light emitting diode (LED), an infra-red beam or any suitable beam.

Since the movable member or rotary arm generally moves relatively slowly there may be a suitable interval between each set of two samplings from the photodetector during which the components used to perform the method may be inactive to conserve energy so that power may be provided by a battery with suitably long life.

Clearly the two samplings of the electrical output from photodetector, once whilst the light source is emitting and once whilst it is not, could be performed in either order.

According to a second aspect of the present invention there is provided an apparatus for providing an electrical output from a meter having a movable member arranged to move through a regular path in dependence upon an amount of a commodity measured by the meter, the apparatus comprising a light source to direct a light beam towards a portion of the regular path followed by the movable member, the movable member having a different reflectivity from the portion of the regular path at which the light source is directed, a single photodetector to receive a reflected beam from the portion of the regular path at which the light source is directed or from a portion of the movable member at that portion of its regular path, control means to sample an electrical output from the photodetector whilst the light source is emitting, characterised in that the control means is further operable to sample an electrical output from the photodetector whilst the light source is not emitting, to produce an electrical output signal representative of the difference between the two sampled electrical outputs and to repeat the two samplings and production of an electrical output signal at appropriate intervals.

The apparatus could be installed non-invasively to an existing commodity meter, such as to monitor the movement of a rotating indicator arm of a U6 gas meter. Alternatively it could be embedded within a commodity meter with a mechanically moving commodity measuring means such as a bellows arrangement.

The control means could perform the two samplings in any order.

The various aspects of the invention may be embodied in many ways, but some specific embodiments will now be described by way of example with reference to the accompanying drawings in which:
Figure 1 schematically illustrates an apparatus for providing an electrical output from a meter having a movable member such as a rotary indicator arm;
Figure 2 is a flow diagram showing the steps taken during operation of the apparatus;
Figure 3 shows the device of figure 1 in more detail and
Figure 4 shows an operational time sequence of the apparatus shown in Figure 3.

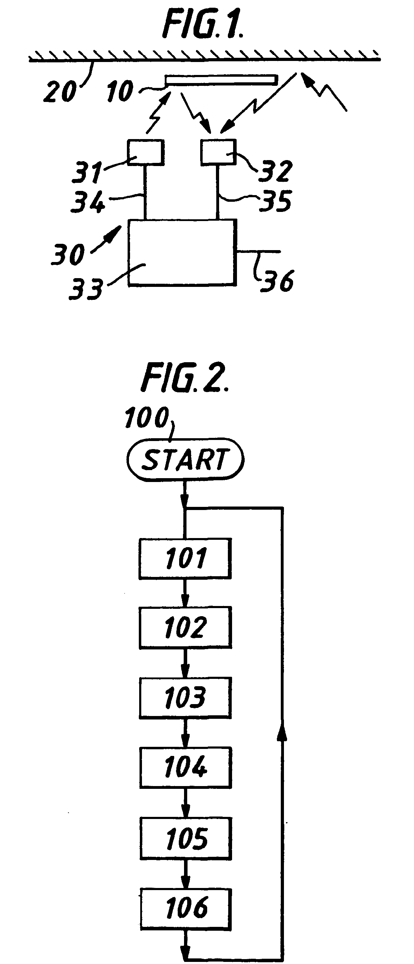

As shown in Figure 1 a meter is provided with a movable member 10 which in this case is a rotary indicator arm, shown in the Figure as an end view, in front of a meter background plate 20. The rotary indicator arm 10 has a different reflectivity from the meter background plate 20, in this case by the two being different colours. Generally the rotary indicator arm 10 is red and the meter background plate is white. The rotary indicator arm 10 will rotate at a rate determined by the amount of commodity measured by the meter.

An apparatus 30 is provided for detecting the rotation of the rotary indicator arm 10 by detecting the passage of the arm 10 past the point of the background plate 20 being monitored as shown in Figure 1. The apparatus 30 is arranged to provide an electrical output indicative of each or of the number of rotations of the rotary indicator arm 10. The apparatus 30 includes a light source 31, which in this case is an LED, to direct light towards a portion of the background plate 20 over which the arm 10 passes. The apparatus also includes a photodetector 32 which receives a reflected beam from the background plate 20 or, as shown in Figure 1, from the arm 10 covering that portion of the background plate. As can be seen in Figure 1 the photodetector may also receive ambient light from other sources which will also be detected by the photodetector. The apparatus 30 also includes a control means 33, in this case a microcontroller, which samples an electrical output from the photodetector 32 when LED 31 is not emitting and then again when it is emitting or vice versa. The control means 33 controls when the LED 31 is emitting using connection 34 and samples the electrical output from photodetector 32 using connection 35. The control means 33 produces an electrical output signal representative of the difference between the two sampled electrical outputs. The control means 33 may output this difference signal but in this case the control means 33 repeats the two samples at suitable intervals and monitors the difference signals produced and produces a pulse on line 36 whenever the difference signal changes which is indicative of the passage of the arm 10 and thus its rotation by one revolution. The control means may store data for later analysis or for reading by any suitable means such as by transmission by a radio transmitter (not shown) to a suitable point such as a remote meter reader.

Figure 2 shows the sequence of steps performed by the control means 33. Starting at step 100 the control means proceeds to step 101 where it samples the electrical output of the photodetector 32 while the LED 31 is not emitting or 'off'. At step 102 the control means 33 turns 'on' the LED 31. At step 103 the control means 33 makes another sample of the electrical output of photodetector 32 while the LED is emitting or turned 'on'. At step 104 the control means 33 turns 'off' the LED and stops sampling the output of photodetector 32. At step 105 the control means determines the difference between the two samples and either outputs this information or stores it for comparison to previous and subsequent difference values to determine when the arm 10 completes a revolution. This information may be produced in the form of a pulse or switch indicating each revolution of the arm 10 or stored for subsequent release and analysis. At step 106 the control means waits a suitable period dependent upon the expected speed of rotation of the arm before proceeding back to step 101 and repeating the process. By waiting a suitable period before making the next sample and illuminating the LED, a considerable amount of electrical energy is saved raising the prospect of being able to power the apparatus with a battery which will not need changing for many years considerably reducing costs.

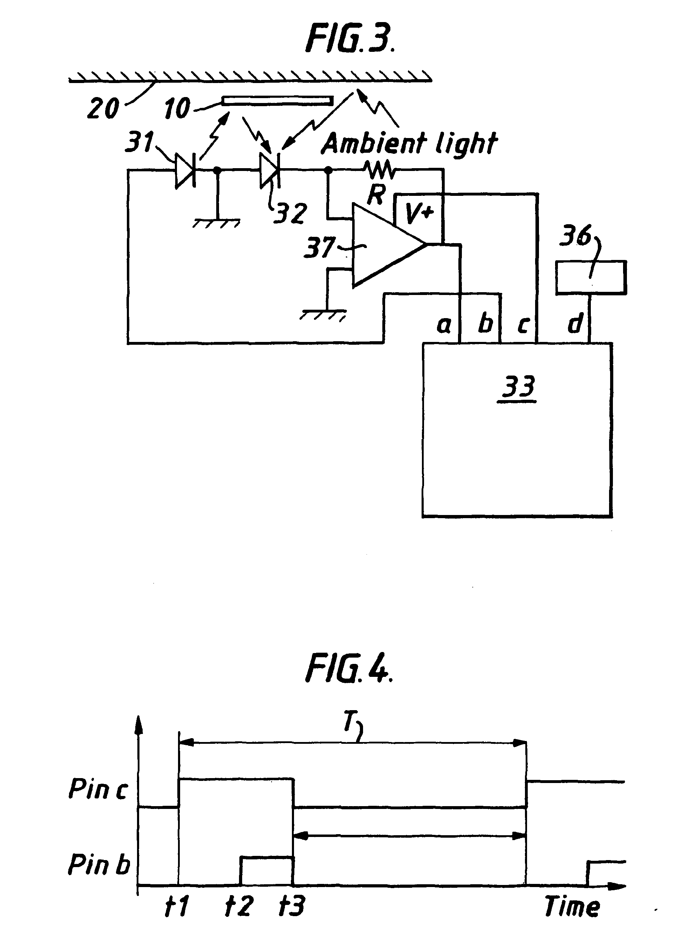

Figure 3 shows the device of Figure 1 in more detail. As previously explained the red rotary indicator arm 10 and the white meter plate background 20 have different optical reflectivity which produce different levels of photo-current on the photodetector 32 which is shown in Figure 3 as a photodiode. The control means 33, in this case a microcontroller, samples the light level through pin a. Pins b and c of the microcontroller are used to supply current to the LED and to power up photo-current amplifier 37 respectively. Pins b and c are only active when measurement is required to reduce power consumption so that the device may be powered by a battery source. Pin b may consist of multiple pins to supply sufficient current to the LED. Pin d is used to output a signal to a meter reading network 36. The output may be a simple switch, a wireless, an optical or a cable-wired communication component.

As shown in Figure 4 the microcontroller samples the photodiode twice per measurement by powering up the photo-current amplifier 37 for a suitable period of time using pin c. During the first sampling starting from time t1, the output of pin b of the microcontroller is low so that the LED is not excited. Pin c is high which powers up the photo-current amplifier 37. The photo-current corresponding to ambient light is converted to voltage by the feedback resistor R and amplified by the amplifier 37. The measured voltage is then sent to the microcontroller through the analog channel pin a. During the second sampling starting from time t2, the microcontroller sets pin b high, and the LED is excited and the light from LED together with the ambient light is measured. At time t3, both pin b and pin c are switched off. In the data processing, the first sample is subtracted from the second one and thus the influence of ambient light is eliminated. Finally, the microcontroller is put into sleep mode to conserve the battery power until the next measurement period.

The sleep mode may last for any suitable period of time depending upon the speed of rotation of the rotary indicator arm 10, but may be from a fraction of a second to a few seconds depending upon the type of meter and the expected consumption of the meter.

It has been found through tests that the amount of current produced by the photo detector 32 will vary due to positioning of the LED 31 and photo detector 32, distance between reflective surface 10, 20 and source LED 31 and photo detector 32, ambient light conditions, device ageing etc.

There exists a mathematical relationship between the photo detector 32 current that flows when readings are taken on the face plate 20 (white background) and readings that are taken on the rotating arm 10.

The mathematical relation is that the ratio of measurement taken under the face plate 20, in this case with a white background, to measurement taken under the rotating arm 10 is almost fixed or substantially constant.

This relationship still exists under the varying condition as described above.

The software running on the micro controller utilises this relationship to overcome all of the problems described above.

Many amendments may be made to the example described above without departing from the wording of the claims. For example the two samples from the photodetector, one with the LED on and one with the LED off, could be made in either order. Furthermore the apparatus may be arranged to be field installed or retrofitted to an existing meter or it may be embedded within a meter.

## Claims

1. A method for providing an electrical output from a meter having a movable member (10) arranged to move through a regular path in dependence upon an amount of a commodity measured by the meter, the method comprising
providing a light source (31) to direct a light beam towards a portion of the regular path (20) followed by the movable member (10) and a photodetector (32) to receive a reflected beam from the portion of the regular path (20) at which the light source (31) is directed or from a portion of the movable member (10) when it is at that portion of its regular path (20), the movable member (10) having a different reflectivity from the portion of the regular path (20) at which the light source (31) is directed;
sampling (103) an electrical output from the photodetector (32) whilst the light source (31) is emitting light;
**characterised by** further including sampling (101) an electrical output from the photodetector (32) whilst the light source (31) is not emitting light;
producing (105) an electrical output signal representative of the difference between the two sampled electrical outputs and
repeating (101-106) the two samplings and production of an electrical output signal at appropriate intervals.

2. A method according to claim 1 wherein the electrical output signal is monitored and when it changes such that it is indicative of the passage of the movable member (10) past the portion of the regular path (20) at which the light source (31) is directed, a further output signal is produced.

3. A method according to claim 2, wherein the further output signal is a pulse.

4. A method according to claim 2 or claim 3, wherein the further output signals are monitored such that information from the further output signals can be downloaded or transmitted when required.

5. A method according to any of the preceding claims, in which at least some of the components are put into a state in which they use less energy when sampling is not being performed.

6. A method according to any of the preceding claims, in which an electrical output from the photodetector (32) whilst the light source (31) is emitting light is sampled (103) before sampling (101) an electrical output from the photodetector (32) whilst the light source (31) is not emitting light.

7. A method according to any of the preceding claims, in which the method is performed non-invasivoly on an existing meter.

8. A method according to any of claims 1 to 6, in which the method is performed by components embedded within a meter.

9. A method according to any of the preceding claims, wherein the ratio of the electrical output from the photo detector (32) whilst receiving a reflected beam from the portion of the regular path or background plate (20) to the electrical output from the photo detector (32) whilst receiving a reflected beam from the movable member (10) is substantially constant.

10. An apparatus for providing an electrical output from a meter having a movable member (10) arranged to move through a regular path (20) in dependence upon an amount of a commodity measured by the meter, the apparatus comprising
a light source (31) to direct a light beam towards a portion of the regular path (20) followed by the movable member (10), the movable member (10) having a different reflectivity from the portion of the regular path (20) at which the light source (31) is directed,
a single photodetector (32) to receive a reflected beam from the portion of the regular path (20) at which the light source (31) is directed or from a portion of the movable member (10) at that portion of its regular path,
control means (33) to sample (103) an electrical output from the photodetector (32) whilst the light source (31) is emitting, **characterised in that** the control means (33) is further operable to sample (101) an electrical output from the photodetector (32) whilst the light source (31) is not emitting, to produce an electrical output signal representative of the difference between the two sampled electrical outputs and to repeat (101-106) the two samplings and production of an electrical output signal at appropriate intervals.

11. An apparatus according to claim 10, wherein the control means (33) is arranged to monitor the electrical output signal such that when it changes in a manner indicative of the passage of the movable member (10) past the portion of the regular path (20) at which the light source is directed, the control means (33) is arranged to produce a further output signal.

12. An apparatus according to claim 11, wherein the further output signal is a pulse.

13. An apparatus according to claim 11 or claim 12, wherein the control means (33) is arranged to monitor the further output signal such that it can provide information about it when required.

14. An apparatus according to any of claims 10 to 13, wherein at least some of the components of the apparatus are arranged to be able to be put into a state in which they use less energy when sampling is not being performed.

15. An apparatus according to any of claims 10 to 14, wherein the light source (31) is a light emitting diode.

16. An apparatus according to any of claims 10 to 15, wherein the apparatus is arranged to be installed non-invasively on an existing commodity meter.

17. An apparatus according to any of claims 10 to 15, wherein the apparatus is arranged to be embedded within a commodity meter.

## Patentansprüche

1. Verfahren zur Bereitstellung einer elektrischen Ausgabe von einem Messgerät mit einem beweglichen Element (10), welches derart angeordnet ist, dass sich dieses über einen geregelten Pfad in Abhängigkeit einer Verbrauchsmenge bewegt, welche von dem Messgerät gemessen worden ist, wobei das Verfahren folgendes aufweist:
Bereitstellen einer Lichtquelle (31), um einen Lichtstrahl in Richtung eines Abschnitts des geregelten Pfades (20) zu leiten, welcher von dem beweglichen Element (10) und einem Fotodetektor (32) verfolgt wird, um einen reflektierten Strahl von dem Abschnitt des geregelten Pfades (20) zu empfangen, auf welchen die Lichtquelle (31) ausgerichtet ist, oder von einem Abschnitt des bewegbaren Elements (10) zu empfangen, wenn sich dieses an dem Abschnitt von dessen geregeltem Pfad (20) befindet, wobei das bewegliche Element (10) dort einen unterschiedlichen Reflektionsgrad von dem Abschnitt des geregelten Pfades (20) aufweist, auf welchen die Lichtquelle (31) ausgerichtet ist;
Abfragen (103) einer elektrischen Ausgabe von dem Fotodetektor (32), während die Lichtquelle (31) Licht emittiert;
**gekennzeichnet durch** das weitere Vorhandensein einer Abfrage (101) einer elektrischen Ausgabe von dem Fotodetektor (32), während die Lichtquelle (31) Licht nicht emittiert;
Erzeugung (105) eines elektrischen Ausgabesignals, welches den Unterschied zwischen den beiden ausgegebenen elektrischen Ausgaben präsentiert und
Wiederholen (101-106) der beiden Ausgaben und Erzeugung eines elektrischen Ausgabesignals in entsprechenden Intervallen.

2. Verfahren nach Anspruch 1, wobei das elektrische Ausgabesignal überwacht wird, und wenn sich dieses ändert, so dass dieses die Passage des beweglichen Elements (10) über den Abschnitt des geregelten Pfades (20) anzeigt, auf welchen die Lichtquelle (31) ausgerichtet ist, wobei ein weiteres Ausgabesignal erzeugt wird.

3. Verfahren nach Anspruch 2, wobei das weitere Ausgabesignal ein Impuls ist.

4. Verfahren nach Anspruch 2 oder 3, wobei die weiteren Ausgabesignale überwacht werden, so dass die Informationen von den weiteren Ausgabesignalen heruntergeladen werden können oder übertragen werden, wenn dies angefordert wird.

5. Verfahren gemäß einem der vorhergehenden Ansprüche, wobei zumindest einige der Komponenten in einen Zustand versetzt werden, in welchen diese weniger Energie verbrauchen, wenn das Abfragen nicht durchgeführt wird.

6. Verfahren gemäß einem der vorhergehenden Ansprüche, wobei eine elektrische Ausgabe von dem Fotodetektor (32) ausgegeben wird (103), während die Lichtquelle (31) Licht emittiert, bevor die Ausgabe (101) eine elektrische Ausgabe von dem Fotodetektor (32) ausgibt, während die Lichtquelle (31) Licht nicht emittiert.

7. Verfahren gemäß einem der vorhergehenden Ansprüche, wobei das Verfahren bei einem existierenden Messapparat nicht angreift.

8. Verfahren gemäß einem der Ansprüche 1 - 6, wobei das Verfahren durch Komponenten durchgeführt wird, welche innerhalb eines Messgeräts eingebettet sind.

9. Verfahren gemäß einem der vorhergehenden Ansprüche, wobei das Verhältnis der elektrischen Ausgabe von dem Fotodetektor (32), während dieser einen reflektierten Strahl von dem Abschnitt des vorbestimmten Pfads oder einer Grundplatte (20) empfängt, zu der elektrischen Ausgabe von dem Fotodetektor (32), während ein reflektierter Strahl von dem bewegbaren Element (10) empfangen wird, im wesentlichen konstant ist.

10. Vorrichtung zur Bereitstellung einer elektrischen Ausgabe von einem Messgerät mit einem bewegbaren Element (10), welches derart angebracht ist, um sich über einen vorbestimmten Pfad (20) in Abhängigkeit einer Verbrauchsmenge zu bewegen, welche von dem Messgerät gemessen worden ist, wobei die Vorrichtung aufweist:
eine Lichtquelle (31), um einen Lichtstrahl in Richtung eines Abschnitts eines vorbestimmten Pfades (20) auszurichten, welcher von dem bewegbaren Element (10) gefolgt wird, wobei das bewegbare Element (10) einen unterschiedlichen Reflektionsgrad von dem Abschnitt des vorbestimmten Pfades (20) aufweist, auf welchen die Lichtquelle (31) ausgerichtet ist,
einen einzelnen Fotodetektor (32), um einen reflektierten Strahl von dem Abschnitt des vorbestimmten Pfades (20) zu empfangen, auf welchen die Lichtquelle (31) ausgerichtet ist, oder von einem Abschnitt des bewegbaren Elements (10) zu empfangen, wobei sich an diesem Abschnitt dessen vorbestimmter Pfad befindet,
Steuereinrichtungen (33), um eine elektrische Ausgabe von dem Fotodetektor (32) abzufragen (103), während die Lichtquelle (31) Licht aussendet, **dadurch gekennzeichnet, dass** die Steuereinrichtungen (33) ferner derart betrieben werden, dass eine elektrische Ausgabe von dem Fotodetektor (32) ausgegeben wird (101), während die Lichtquelle (31) Licht nicht aussendet, um ein elektrisches Ausgabesignal zu erzeugen, welches für den Unterschied zwischen den beiden ausgegebenen elektrischen Ausgaben repräsentativ ist, und um die beiden Ausgaben und die Erzeugung eines elektrischen Ausgabesignals in entsprechenden Intervallen zu wiederholen (101 - 106).

11. Vorrichtung gemäß Anspruch 10, wobei die Steuereinrichtungen (33) derart angeordnet sind, um das elektrische Ausgabesignal zu überwachen, so dass wenn sich dieses in einer anzeigenden Art und Weise im Hinblick auf die Passage des bewegbaren Elements (10) über den Abschnitt des vorbestimmten Pfades (20) hinaus ändert, auf welchen die Lichtquelle ausgerichtet ist, wobei die Steuereinrichtungen (33) derart angeordnet sind, um ein weiteres Ausgabesignal zu erzeugen.

12. Vorrichtung nach Anspruch 11, wobei das weitere Ausgabesignal ein Impuls ist.

13. Vorrichtung nach Anspruch 11 oder Anspruch 12, wobei die Steuereinrichtungen (33) derart angeordnet sind, um das weitere Ausgabesignal zu überwachen, so dass diese Informationen darüber bereitstellen kann, wenn dies angefordert wird.

14. Vorrichtung gemäß einem der Ansprüche 10 bis 13, wobei zumindest einige der Komponenten der Vorrichtung derart angeordnet sind, dass diese dazu fähig sind, in einen Zustand versetzt zu werden, in welchen diese weniger Energie verbrauchen, wenn ein Abfragen nicht durchgeführt wird.

15. Vorrichtung gemäß einem der Ansprüche 10 bis 14, wobei die Lichtquelle (31) eine Licht emittierende Diode ist.

16. Vorrichtung gemäß einem der Ansprüche 10 bis 15, wobei die Vorrichtung derart angeordnet ist, dass diese für ein existierendes Verbrauchsmessgerät in nicht angreifender Art installiert ist.

17. Vorrichtung gemäß einem der Ansprüche 10 bis 15, wobei die Vorrichtung derart angeordnet ist, dass diese innerhalb eines Verbrauchsmessgeräts eingebettet ist.

## Revendications

1. Procédé permettant de produire une sortie électrique à partir d'un compteur comprenant un élément mobile (10) agencé pour se déplacer sur une trajectoire régulière en fonction de la quantité de produit mesurée par le compteur, le procédé comprenant
la disposition d'une source lumineuse (31) dirigeant un faisceau lumineux sur une portion de la trajectoire régulière (20) suivie par l'élément mobile (10), et d'un photodétecteur (32) qui reçoit le faisceau réfléchi par la portion de la trajectoire régulière (20) sur laquelle la source lumineuse (31) est dirigée ou par une portion de l'élément mobile (10) lorsqu'il se trouve dans cette même portion de sa trajectoire régulière (20), l'élément mobile (10) présentant une réflectivité différente de la portion de la trajectoire régulière (20) sur laquelle la source lumineuse (31) est dirigée ;
l'échantillonnage (103) de la sortie électrique du photodétecteur (32) pendant que la source lumineuse (31) émet de la lumière ;
**caractérisé en ce qu'**il comprend encore l'échantillonnage (101) d'une sortie électrique du photodétecteur (32) pendant que la source lumineuse (31) n'émet pas de lumière ;
la production (105) d'un signal de sortie électrique représentatif de la différence entre les deux sorties électriques échantillonnées, et
la répétition (101-106) des deux échantillonnages et la production d'un signal de sortie électrique à intervalles appropriés.

2. Procédé selon la revendication 1, dans lequel le signal de sortie électrique est surveillé et lorsqu'il change de manière à indiquer le passage de l'élément mobile (10) devant la portion de la trajectoire régulière (20) sur laquelle la source lumineuse (31) est dirigée, il se produit un autre signal de sortie électrique.

3. Procédé selon la revendication 2, dans lequel l'autre signal de sortie électrique est une impulsion.

4. Procédé selon la revendication 2 ou la revendication 3, dans lequel les autres signaux de sortie électriques sont surveillés de sorte que les informations issues des autres signaux de sortie électriques puissent être téléchargées ou transmises au besoin.

5. Procédé selon l'une quelconque des revendications précédentes, dans lequel au moins certains des composants sont placés dans un état dans lequel ils consomment moins d'énergie lorsque l'échantillonnage n'est pas en cours de réalisation.

6. Procédé selon l'une quelconque des revendications précédentes, dans lequel une sortie électrique du photodétecteur (32) est échantillonnée (103) pendant que la source lumineuse (31) émet de la lumière et ce avant l'échantillonnage (101) d'une sortie électrique du photodétecteur (32) effectué pendant que la source lumineuse (31) n'émet pas de lumière.

7. Procédé selon l'une quelconque des revendications précédentes, dans lequel le procédé est mis en oeuvre de manière non invasive sur un compteur préexistant.

8. Procédé selon l'une quelconque des revendications 1 à 6, dans lequel le procédé est réalisé par des composants incorporés dans un compteur.

9. Procédé selon l'une quelconque des revendications précédentes, dans lequel le rapport existant entre la sortie électrique du photodétecteur (32) pendant la réception d'un faisceau réfléchi par la portion de la trajectoire régulière ou plaque de fond (20) et la sortie électrique du photodétecteur (32) pendant la réception d'un faisceau réfléchi par l'élément mobile (10) est sensiblement constant.

10. Appareil permettant de produire une sortie électrique à partir d'un compteur comprenant un élément mobile (10) agencé pour se déplacer sur une trajectoire régulière (20) en fonction de la quantité de produit mesurée par le compteur, l'appareil comprenant
une source lumineuse (31) dirigeant un faisceau lumineux sur une portion de la trajectoire régulière (20) suivie par l'élément mobile (10), l'élément mobile (10) présentant une réflectivité différente de la portion de la trajectoire régulière (20) sur laquelle la source lumineuse (31) est dirigée,
un photodétecteur unique (32) qui reçoit le faisceau réfléchi par la portion de la trajectoire régulière (20) sur laquelle la source lumineuse (31) est dirigée ou par une portion de l'élément mobile (10) dans cette même portion de sa trajectoire régulière,
un moyen de commande (33) permettant d'échantillonner (103) une sortie électrique du photodétecteur (32) pendant que la source lumineuse (31) émet de la lumière, **caractérisé en ce que** le moyen de commande (33) est encore fonctionnel pour échantillonner (101) une sortie électrique du photodétecteur (32) pendant que la source lumineuse (31) n'émet pas de lumière, pour produire un signal de sortie électrique représentatif de la différence entre les deux sorties électriques échantillonnées et pour répéter (101-106) les deux échantillonnages et la production d'un signal de sortie électrique à intervalles appropriés.

11. Appareil selon la revendication 10, dans lequel le moyen de commande (33) est agencé pour surveiller le signal de sortie électrique de sorte que lorsque celui-ci change de manière à indiquer le passage de l'élément mobile (10) devant la portion de la trajectoire régulière (20) sur laquelle la source lumineuse est dirigée, le moyen de commande (33) produit un autre signal de sortie électrique.

12. Appareil selon la revendication 11, dans lequel l'autre signal de sortie électrique est une impulsion.

13. Appareil selon la revendication 11 ou la revendication 12, dans lequel le moyen de commande (33) est agencé pour surveiller l'autre signal de sortie électrique de sorte à pouvoir fournir, au besoin, des informations relatives à ce dernier.

14. Appareil selon l'une quelconque des revendications 10 à 13, dans lequel au moins certains des composants de l'appareil sont agencés pour pouvoir être placés dans un état dans lequel ils consomment moins d'énergie lorsque l'échantillonnage n'est pas en cours de réalisation.

15. Appareil selon l'une quelconque des revendications 10 à 14, dans lequel la source lumineuse (31) est une diode électroluminescente.

16. Appareil selon l'une quelconque des revendications 10 à 15, dans lequel l'appareil est agencé pour être installé de manière non invasive sur un compteur de consommation préexistant.

17. Appareil selon l'une quelconque des revendications 10 à 15, dans lequel l'appareil est agencé pour être incorporé dans un compteur de consommation.
